# EUROPEAN PATENT APPLICATION

(11) **EP 4 310 630 A1**
(43) Date of publication of application: **24.01.2024**
(21) Application number: 22876702.6
(22) Date of filing: 06.09.2022
(51) Int. Cl.: G06F 1/16, G09F 9/30

(54) **FOLDABLE ELECTRONIC DEVICE COMPRISING DISPLAY PROTECTION STRUCTURE**

(30) Priority: 29.09.2021 KR 20210128749
(71) Applicant: Samsung Electronics Co., Ltd., Suwon-si, Gyeonggi-do 16677 (KR)
(72) Inventor: PARK, Jungwon, Suwon-si, Gyeonggi-do 16677 (KR); KIM, Chijoon, Suwon-si, Gyeonggi-do 16677 (KR); SHIM, Jaesung, Suwon-si, Gyeonggi-do 16677 (KR); JEON, Minsu, Suwon-si, Gyeonggi-do 16677 (KR); YOO, Minwoo, Suwon-si, Gyeonggi-do 16677 (KR)
(74) Representative: Gulde & Partner
(86) International application number: PCT/KR2022/013317
(87) International publication number: WO 2023/054927

(57) **Abstract**

An electronic device includes: a first housing; a second housing; at least one hinge device which connects the first housing and the second housing to be foldable with respect to each other with reference to a folding axis; a hinge housing which receives the at least one hinge device; a flexible display including a first region corresponding to the first housing, a second region corresponding to the second housing, and a folding area which is foldable and connects the first region and the second region; and at least one protective member which is coupled, in an area corresponding to the folding area, to the hinge housing to be rotatable with reference to a rotation axis parallel to the folding axis, the protective member including a material which is at least partially deformable according to a folding operation of the electronic device, wherein the at least one protective member at least partially overlaps at least one edge of the flexible display in the folding area when the flexible display is viewed from above..

## Description

### [Technical Field]

The disclosure relate to a foldable electronic device including a display protection structure.

### [Background Art]

Electronic devices have become slimmer and tend to have increased rigidity, enhanced design aspects, and improved functional elements for differentiation. Such electronic devices are evolving to have various shapes, other than the conventional uniform rectangular shape. For example, an electronic device may have a transformable structure which provides convenient portability and allows use of a large-screen display when the electronic device is used. For example, an electronic device may include a foldable electronic device that operates in such a way that at least two housings are folded or unfolded with respect to each other, and various improvements are provided to solve problems caused by a folding structure.

### [Disclosure of Invention]

### [Technical Problem]

A foldable electronic device may include a hinge device (e.g., a hinge module, a hinge structure, or a hinge unit), and a first housing (e.g., a first housing structure) and a second housing (e.g., a second housing structure), each of which is connected to the hinge device in a direction facing the hinge device. The first housing may be rotated in a range of 0 degrees to 180 degrees with respect to the second housing via the hinge device, and thus the foldable electronic device may be operated in an in-folding manner or in an out-folding manner. The foldable electronic device may include a flexible display disposed across the first housing and the second housing to be viewed from the outside in a state in which the foldable electronic device is opened approximately 180 degrees.

Because the flexible display should be folded together with the housings, the flexible electronic device may not include a rigid body (e.g., a front window or a window glass) for protecting the flexible display, unlike general bar-type electronic devices. Therefore, the foldable electronic device may be fixed to the housings in a state in which a protective layer (e.g., a polyimide (PI) film and/or ultra-thin glass (UTG)) is disposed on an upper surface of the flexible display, and the edges thereof may be concealed via a separate protection cover (e.g., a protective frame or a decorative member). In an embodiment, a foldable electronic device may include only a flexible display disposed without a protection cover.

However, a foldable electronic device may include, in a folding area, a cut-out space in which a protective frame is cut to provide a degree of freedom in bending of the hinge device according to a folding operation. For example, via the cut-out space, the edges of the flexible display are exposed to not only allow foreign matter to be introduced into the space, but also allow a user to lift the edges of the flexible display arbitrarily with his/her fingers or a sharp tool, and thus the flexible display may be broken or a malfunction may be induced.

Various embodiments of the disclosure may provide a foldable electronic device including a display protection structure.

According to various embodiments, an electronic device including a display protection structure, which can perform an effective protective function, may be provided.

According to various embodiments, an electronic device including a display protection structure, which has excellent assembly and can reduce manufacturing costs, may be provided.

According to various embodiments, an electronic device including a display protection structure, which The problems to be solved in the disclosure are not limited to the above mentioned problems, and may be variously expanded without departing from the spirit and scope of the disclosure.

### [Solution to Problem]

According to an aspect of the disclosure, an electronic device includes: a first housing; a second housing; at least one hinge device which connects the first housing and the second housing to be foldable with respect to each other with reference to a folding axis; a hinge housing which receives the at least one hinge device; a flexible display including a first region corresponding to the first housing, a second region corresponding to the second housing, and a folding area which is foldable and connects the first region and the second region; and at least one protective member which is coupled, in an area corresponding to the folding area, to the hinge housing to be rotatable with reference to a rotation axis parallel to the folding axis, the protective member including a material which is at least partially deformable according to a folding operation of the electronic device, wherein the at least one protective member at least partially overlaps at least one edge of the flexible display in the folding area when the flexible display is viewed from above.

### [Advantageous Effects of invention]

Embodiments of the disclosure include, via the hinge housing, a protective member disposed to protect the edges of a flexible display via the protective member disposed to be rotatable, and thus the flexible display can be efficiently protected, the number of components can be decreased to reduce manufacturing costs, excellent assembly can be achieved via structural change to help improve productivity.

In addition, various effects directly or indirectly identified via the disclosure may be provided.

### [Brief Description of Drawings]

The above and other aspects, features, and advantages of certain embodiments of the present disclosure will be more apparent from the following description taken in conjunction with the accompanying drawings, in which:
FIG. 1A is a front perspective view of an electronic device illustrating an unfolded state (flat state or unfolding state) according to an embodiment;
FIG. 1B is a plan view illustrating a front surface of the electronic device, in an unfolded state according to an embodiment;
FIG. 1C is a plan view illustrating a rear surface of the electronic device, in an unfolded state according to an embodiment;
FIG. 2A is a perspective view of an electronic device illustrating a folded state (folding state) according to an embodiment;
FIG. 2B is a perspective view of the electronic device illustrating an intermediate state according to an embodiment;
FIG. 3 is an exploded perspective view of an electronic device according to an embodiment;
FIG. 4A is a perspective view of a protective member according to an embodiment;
FIG. 4B is a front view of the protective member according to an embodiment;
FIG. 4C is a bottom view of the protective member according to an embodiment;
FIG. 5 is a partial perspective view of the hinge housing according to an embodiment;
FIG. 6A is a partial sectional perspective view of the electronic device on which a protective member is disposed, in area 6a of FIG; 1A according to an embodiment.
FIG; 6B is a partial cross-sectional view of the electronic device taken along line 6b-6b of FIG. 6A according to an embodiment;
FIG. 7A is a partial configuration view of the electronic device illustrating an unfolded state according to an embodiment;
FIG. 7B and FIG. 7C are partial configuration views of the electronic device illustrating a folded state according to various an embodiment;
FIG. 8 is a partial plan view of the electronic device on which a protective member is disposed according to an embodiment;
FIG. 9A and FIG. 9B are perspective views of protective members according to an embodiment;
FIG. 10A is an exploded perspective view of a hinge housing and a protective member according to an embodiment;
FIG. 10B are a perspective view illustrating a state in which the protective member is coupled to the hinge housing according to an embodiment;
FIG. 10C is a cross-sectional view of the protective member taken along line 10c-10c of FIG. 10A according to an embodiment; and
FIG. 11 is a partial plan view of the electronic device on which a protective member and a blocking film are disposed according to an embodiment.

### [Mode for the Invention]

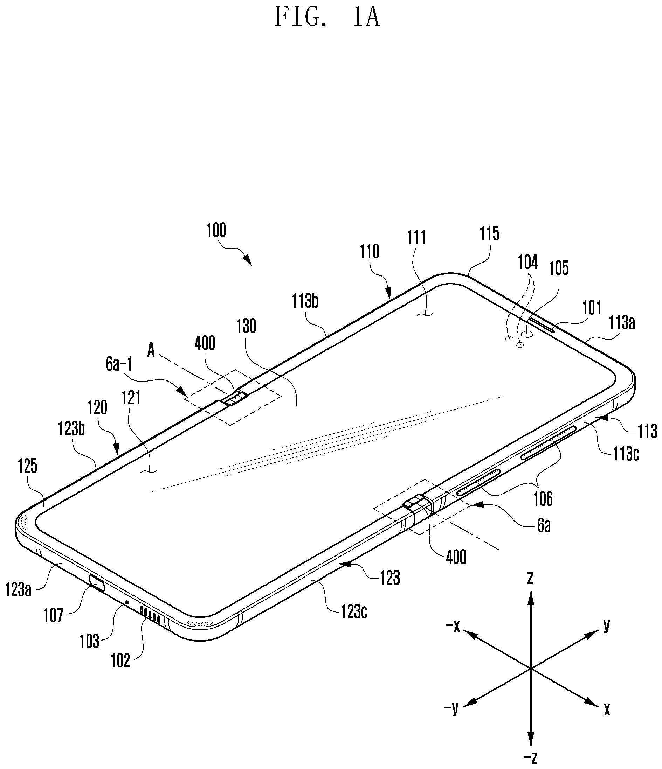

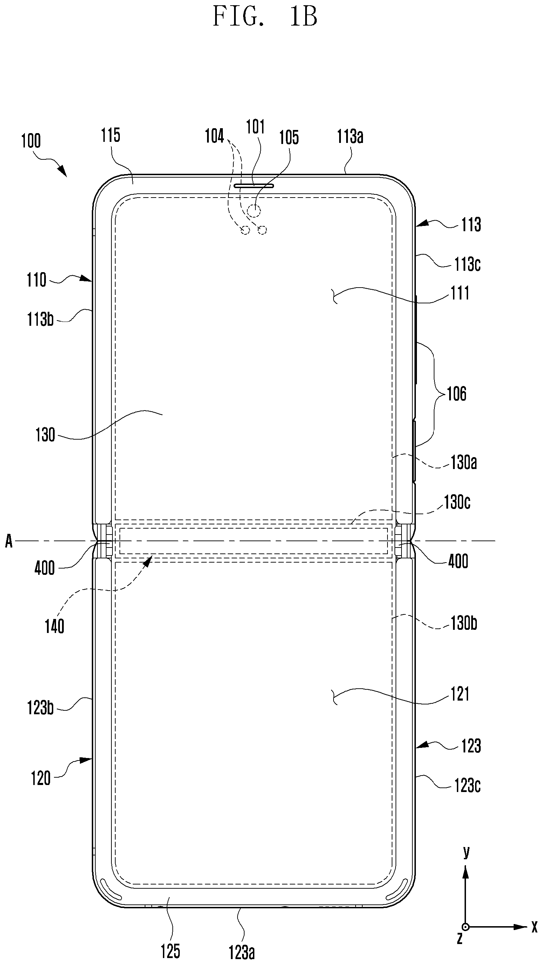

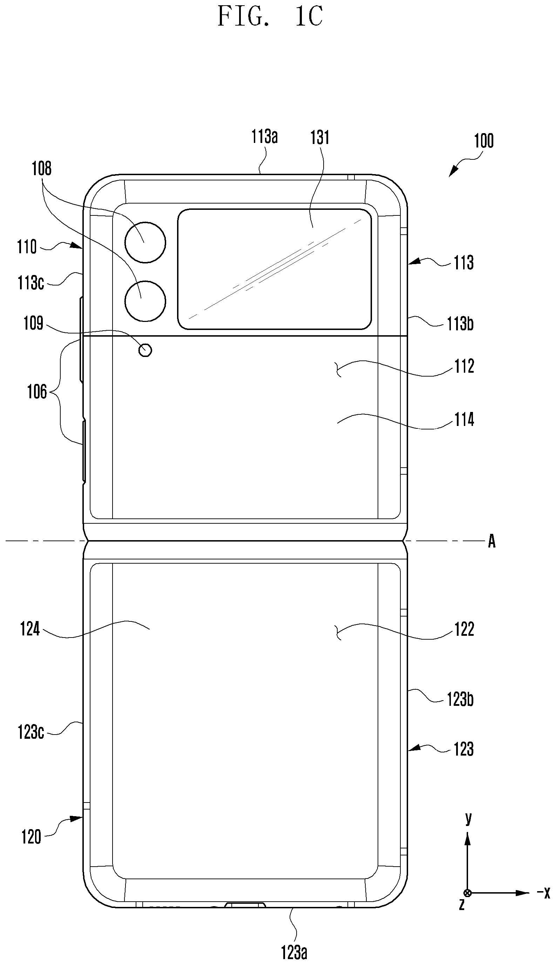

FIG. 1A is a front perspective view of an electronic device in a flat or unfolded state according to various embodiments of the disclosure. FIG. 1B is a diagram illustrating the front of the electronic device in an unfolded state according to various embodiments. FIG. 1C is a diagram illustrating the back of the electronic device in an unfolded state according to various embodiments.

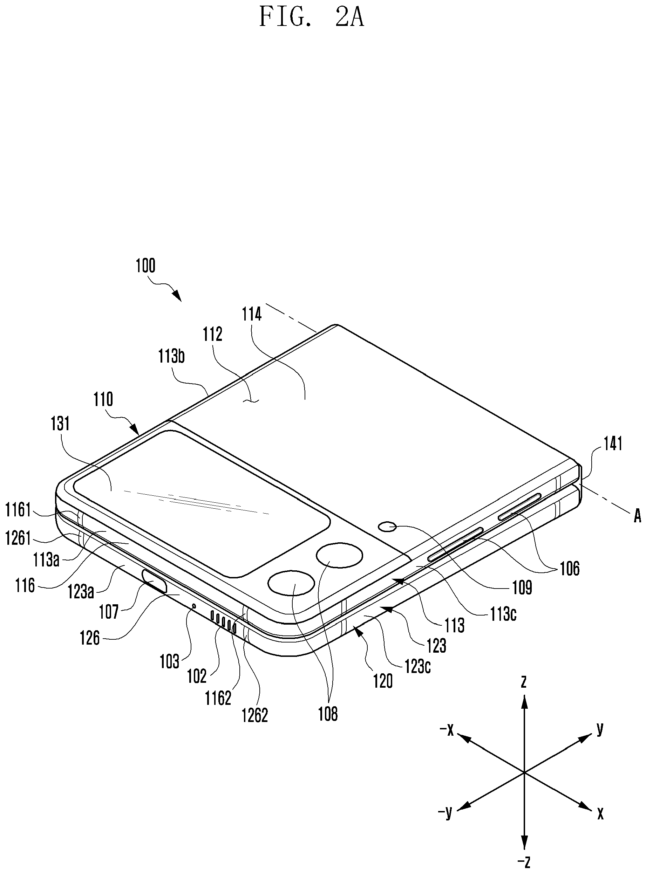

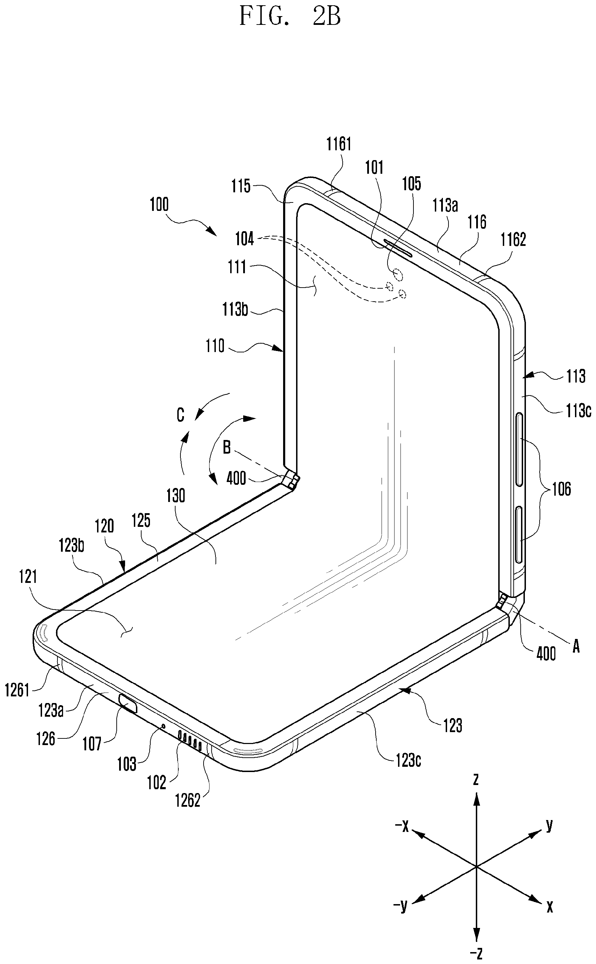

FIG. 2A is a perspective view of the electronic device in a folded state according to various embodiments. FIG. 2B is a perspective view of the electronic device in an intermediate state according to various embodiments.

With reference to FIGS. 1A, 1B, 1C, 2A and 2B, the electronic device 100 may include a pair of housings 110 and 120 (e.g., foldable housings) that are rotatably coupled as to allow folding relative to a hinge mechanism (e.g., hinge mechanism 140 in FIG. 1B). In various embodiments, the hinge mechanism (e.g., hinge mechanism 140 in FIG. 1B) may be disposed in the X-axis direction or in the Y-axis direction. In certain embodiments, two or more hinge mechanisms (e.g., hinge mechanism 140 in FIG. 1B) may be arranged to be folded in a same direction or in different directions. According to an embodiment, the electronic device 100 may include a flexible display 130 (e.g., foldable display) disposed in an area formed by the pair of housings 110 and 120. According to an embodiment, the first housing 110 and the second housing 120 may be disposed on both sides about the folding axis (axis A), and may have a substantially symmetrical shape with respect to the folding axis (axis A). According to an embodiment, the angle or distance between the first housing 110 and the second housing 120 may vary, depending on whether the state of the electronic device 100 is a flat or unfolded state, a folded state, or an intermediate state.

According to certain embodiments, the pair of housings 110 and 120 may include a first housing 110 (e.g., first housing structure) coupled to the hinge mechanism (e.g., hinge mechanism 140 in FIG. 1B), and a second housing 120 (e.g., second housing structure) coupled to the hinge mechanism (e.g., hinge mechanism 140 in FIG. 1B). According to an embodiment, in the unfolded state, the first housing 110 may include a first surface 111 facing a first direction (e.g., front direction) (z-axis direction), and a second surface 112 facing a second direction (e.g., rear direction) (negative z-axis direction) opposite to the first surface 111. According to an embodiment, in the unfolded state, the second housing 120 may include a third surface 121 facing the first direction (z-axis direction), and a fourth surface 122 facing the second direction (negative z-axis direction). According to an embodiment, the electronic device 100 may be operated in such a manner that the first surface 111 of the first housing 110 and the third surface 121 of the second housing 120 face substantially the same first direction (z-axis direction) in the unfolded state, and the first surface 111 and the third surface 121 face one another in the folded state. According to an embodiment, the electronic device 100 may be operated in such a manner that the second surface 112 of the first housing 110 and the fourth surface 122 of the second housing 120 face substantially the same second direction (negative z-axis direction) in the unfolded state, and the second surface 112 and the fourth surface 122 face one another in opposite directions in the folded state. For example, in the folded state, the second surface 112 may face the first direction (z-axis direction), and the fourth surface 122 may face the second direction (negative z-axis direction).

According to certain embodiments, the first housing 110 may include a first side member 113 that at least partially forms an external appearance of the electronic device 100, and a first rear cover 114 coupled to the first side member 113 that forms at least a portion of the second surface 112 of the electronic device 100. According to an embodiment, the first side member 113 may include a first side surface 113a, a second side surface 113b extending from one end of the first side surface 113a, and a third side surface 113c extending from the other end of the first side surface 113a. According to an embodiment, the first side member 113 may be formed in a rectangular shape (e.g., square or rectangle) through the first side surface 113a, second side surface 113b, and third side surface 113c.

According to certain embodiments, the second housing 120 may include a second side member 123 that at least partially forms the external appearance of the electronic device 100, and a second rear cover 124 coupled to the second side member 123, forming at least a portion of the fourth surface 122 of the electronic device 100. According to an embodiment, the second side member 123 may include a fourth side surface 123a, a fifth side surface 123b extending from one end of the fourth side surface 123a, and a sixth side surface 123c extending from the other end of the fourth side surface 123a. According to an embodiment, the second side member 123 may be formed in a rectangular shape through the fourth side surface 123a, fifth side surface 123b, and sixth side surface 123c.

According to certain embodiments, the pair of housings 110 and 120 are not limited to the shape and combinations illustrated herein, and may be implemented with a combination of other shapes or parts. For example, in certain embodiments, the first side member 113 may be integrally formed with the first rear cover 114, and the second side member 123 may be integrally formed with the second rear cover 124.

According to certain embodiments, in the unfolded state of the electronic device 100, the second side surface 113b of the first side member 113 and the fifth side surface 123b of the second side member 123 may be connected without a gap formed therebetween. According to an embodiment, in the unfolded state of the electronic device 100, the third side surface 113c of the first side member 113 and the sixth side surface 123c of the second side member 123 may be connected without a gap formed therebetween. According to an embodiment, in the unfolded state, the electronic device 100 may be configured such that the combined length of the second side surface 113b and the fifth side surface 123b is longer than the combined length of the first side surface 113a and/or the fourth side surface 123a. In addition, the combined length of the third side surface 113c and the sixth side surface 123c may be configured to be longer than the length of the first side surface 113a and/or the fourth side surface 123a. In various embodiments, in the unfolding state, the device 100 may be configured such that the sum of the lengths of the second side surface 113b and the fifth side surface 123b is shorter than or equal to the length of the first side surface 113a and/or the fourth side surface 123a. In addition, the sum of the lengths of the third side surface 113c and the sixth side surface 123c may be configured to be shorter than or equal to the length of the first side surface 113a and/or the fourth side surface 123a.

According to certain embodiments, the first side member 113 and/or the second side member 123 may be formed of a metal, and may further include a polymer injected into the metal. According to an embodiment, the first side member 113 and/or the second side member 123 may include at least one conductive portion 116 and/or 126 electrically segmented through one or more segmenting portions 1161 and 1162 and/or segmenting 1261 and 1262, which may be formed using a polymer. In this case, the at least one conductive portion may be electrically connected to a wireless communication circuit included in the electronic device 100, and may be used as an antenna operating in at least one designated band (e.g., legacy band).

According to certain embodiments, the first rear cover 114 and/or the second rear cover 124 may be formed of, for example, coated or tinted glass, ceramic, polymer, metal (e.g., aluminum, stainless steel or "STS", or magnesium), or a combination thereof.

According to certain embodiments, the flexible display 130 may be disposed to extend from the first surface 111 of the first housing 110 across the hinge mechanism (e.g., hinge mechanism 140 in FIG. 1B) to at least a portion of the third surface 121 of the second housing 120. For example, the flexible display 130 may include a first region 130a substantially corresponding to the first surface 111, a second region 130b corresponding to the second surface 121, and a third region 130c (e.g., the bendable region) connecting the first region 130a and the second region 130b and corresponding to the hinge mechanism (e.g., hinge mechanism 140 in FIG. 1B). According to an embodiment, the electronic device 100 may include a first protection cover 115 (e.g., first protection frame or first decoration member) coupled along the periphery of the first housing 110. According to an embodiment, the electronic device 100 may include a second protection cover 125 (e.g., second protection frame or second decoration member) coupled along the periphery of the second housing 120. According to an embodiment, the first protection cover 115 and/or the second protection cover 125 may be formed of a metal or polymer material. According to an embodiment, the first protection cover 115 and/or the second protection cover 125 may be used as a decorative member. According to an embodiment, the flexible display 130 may be positioned such that the periphery of the first region 130a is interposed between the first housing 110 and the first protection cover 115. Accordingto an embodiment, the flexible display 130 may be positioned such that the periphery of the second region 130b is interposed between the second housing 120 and the second protection cover 125. According to an embodiment, the flexible display 130 may be positioned such that the periphery of the flexible display 130 corresponding to a protection cap 135 is protected through the protection cap disposed in a region corresponding to the hinge mechanism (e.g., hinge mechanism 140 in FIG. 1B). Consequently, the periphery of the flexible display 130 may be substantially protected from the outside. According to an embodiment, the electronic device 100 may include a hinge housing 141 (e.g., hinge cover) that is disposed so as to support the hinge mechanism (e.g., hinge mechanism 140 in FIG. 1B). The hinge housing 141 may further be exposed to the outside when the electronic device 100 is in the folded state, and be invisible as viewed from the outside when retracted into a first space (e.g., internal space of the first housing 110 ) and a second space (e.g., internal space of the second housing 120) when the electronic device 100 is in the unfolded state. In certain embodiments, the flexible display 130 may be disposed to extend from at least a portion of the second surface 112 to at least a portion of the fourth surface 122. In this case, the electronic device 100 may be folded so that the flexible display 130 is exposed to the outside (out-folding scheme).

According to certain embodiments, the electronic device 100 may include a sub-display 131 disposed separately from the flexible display 130. According to an embodiment, the sub-display 131 may be disposed to be at least partially exposed on the second surface 112 of the first housing 110, and may display status information of the electronic device 100 in place of the display function of the flexible display 130 in case of the folded state. According to an embodiment, the sub-display 131 may be disposed to be visible from the outside through at least some region of the first rear cover 114. In certain embodiments, the sub-display 131 may be disposed on the fourth surface 122 of the second housing 120. In this case, the sub-display 131 may be disposed to be visible from the outside through at least some region of the second rear cover 124.

According to certain embodiments, the electronic device 100 may include at least one of an input device 103 (e.g., microphone), sound output devices 101 and 102, a sensor module 104, camera devices 105 and 108, a key input device 106, or a connector port 107. In the illustrated embodiment, the input device 103 (e.g., microphone), sound output devices 101 and 102, sensor module 104, camera devices 105 and 108, key input device 106, and connector port 107 indicate a hole or shape formed in the first housing 110 or the second housing 120, but may be defined to include a substantial electronic component (e.g., input device, sound output device, sensor module, or camera device) that is disposed inside the electronic device 100 and operated through a hole or a shape.

According to certain embodiments, the input device 103 may include at least one microphone disposed on the second housing 120. In certain embodiments, the input device 103 may include a plurality of microphones disposed to detect the direction of a sound. In certain embodiments, a plurality of microphones may be disposed at appropriate positions in the first housing 110 and/or the second housing 120. According to an embodiment, the sound output devices 101 and 102 may include speakers. According to an embodiment, the input device 103 may include a receiver for calls disposed in the first housing 110, and a speaker disposed in the second housing 120. In certain embodiments, the input device 103, the sound output devices 101 and 102, and the connector port 107 may be disposed in a space arranged in the first housing 110 and/or the second housing 120 of the electronic device 100, and may be exposed to the external environment through at least one hole formed in the first housing 110 and/or the second housing 120. According to an embodiment, at least one connector port 107 may be used to transmit and receive power and/or data to and from an external electronic device. In certain embodiments, at least one connector port (e.g., ear jack hole) may accommodate a connector (e.g., ear jack) for transmitting and receiving an audio signal to and from an external electronic device. In certain embodiments, the hole formed in the first housing 110 and/or the second housing 120 may be commonly used for the input device 103 and the sound output devices 101 and 102. In certain embodiments, the sound output devices 101 and 102 may include a speaker (e.g., piezo speaker) that operates without using a hole formed in the first housing 110 and/or the second housing 120.

According to certain embodiments, the sensor module 104 may generate an electrical signal or data value corresponding to an internal operating state of the electronic device 100 or an external environmental state. The sensor module 104 may detect an external environment, for example, through the first surface 111 of the first housing 110. In certain embodiments, the electronic device 100 may further include at least one sensor module disposed to detect an external environment through the second surface 112 of the first housing 110. According to an embodiment, the sensor module 104 (e.g., illuminance sensor) may be disposed under the flexible display 130 to detect an external environment through the flexible display 130. According to an embodiment, the sensor module 104 may include at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, an illuminance sensor, a proximity sensor, a biometric sensor, an ultrasonic sensor, or an illuminance sensor 104.

According to certain embodiments, the camera devices 105 and 108 may include a first camera device 105 (e.g., front camera device) disposed on the first surface 111 of the first housing 110, and a second camera device 108 disposed on the second surface 112 of the first housing 110. The electronic device 100 may further include a flash 109 disposed close to the second camera device 108. According to an embodiment, the camera device 105 or 108 may include one or more lenses, an image sensor, and/or an image signal processor. The flash 109 may include, for example, a light emitting diode or a xenon lamp. According to an embodiment, the camera devices 105 and 108 may be arranged so that two or more lenses (e.g., wide-angle lens, super-wide-angle lens, or telephoto lens) and image sensors are positioned on one surface (e.g., first surface 111, second surface 112, third surface 121, or fourth surface 122) of the electronic device 100. In certain embodiments, the camera devices 105 and 108 may include time-of-flight (TOF) lenses and/or an image sensor.

According to certain embodiments, the key input device 106 (e.g., key button) may be disposed on the third side surface 113c of the first side member 113 of the first housing 110. In certain embodiments, the key input device 106 may be disposed on at least one of the other side surfaces 113a and 113b of the first housing 110 and/or the side surfaces 123a, 123b and 123c of the second housing 120. In certain embodiments, the electronic device 100 may not include some or all of the key input devices 106, and those not included key input devices 106 may be implemented in other forms, such as soft keys, on the flexible display 130. In certain embodiments, the key input device 106 may be implemented using a pressure sensor included in the flexible display 130.

According to certain embodiments, some of the camera devices 105 and 108 (e.g., first camera device 105) or the sensor module 104 may be disposed to be exposed through the flexible display 130. For example, the first camera device 105 or the sensor module 104 may be arranged in the internal space of the electronic device 100 so as to be in contact with the external environment through an opening (e.g., through hole) formed at least partially in the flexible display 130. In another embodiment, some sensor modules 104 may be arranged in the internal space of the electronic device 100 so as to perform their functions without being visually exposed through the flexible display 130. For example, in this case, the opening of a region of the flexible display 130 facing the sensor module may be not needed.

With reference to FIG. 2B, the electronic device 100 may be operated to remain in an intermediate state through the hinge mechanism (e.g., hinge device 140 in FIG. 1B). In this case, the electronic device 100 may control the flexible display 130 to display different pieces of content on the display area corresponding to the first surface 111 and the display area corresponding to the third surface 121. According to an embodiment, the electronic device 100 may be operated substantially in an unfolded state (e.g., unfolded state of FIG. 1A) and/or substantially in a folded state (e.g., folded state of FIG. 2A) with respect to a specific inflection angle (e.g., angle between the first housing 110 and the second housing 120 in the intermediate state) through the hinge mechanism (e.g., hinge mechanism 140 in FIG. 1B). For example, when a pressing force is applied in the unfolding direction (B direction) in a state where the electronic device 100 is unfolded at a specific inflection angle, through the hinge mechanism (e.g., hinge mechanism 140 in FIG. 1B), the electronic device 100 may be transitioned to an unfolded state (e.g., unfolded state of FIG. 1A). For example, when a pressing force is applied in the folding direction (C direction) in a state where the electronic device 100 is unfolded at a specific inflection angle, through the hinge mechanism (e.g., hinge mechanism 140 in FIG. 1B), the electronic device 100 may be transitioned to a closed state (e.g., folded state of FIG. 2A). In an embodiment, the electronic device 100 may be operated to remain in an unfolded state at various angles (not shown) through the hinge mechanism (e.g., hinge mechanism 140 in FIG. 1B).

FIGS. 1A, 1B, 1C, 2A and 2B illustrate an in-folding scheme in which the first surface 111 of the first housing 110 and the third surface 121 of the second housing 120 face substantially the same first direction (the z-axis direction) when the electronic device 100 is in a flat state or unfolding state, and in which the first surface 111 and the third surface 121 face each other when the electronic device 100 is in a folded state. According to an embodiment, there may be an out-folding scheme in which, the first surface 111 of the first housing 110 and the third surface 121 of the second housing 120 face substantially the same first direction (the z-axis direction) when the electronic device 100 is in a flat state or unfolding state and in which the second surface 112 and the fourth surface 122 face each other when the electronic device 100 is in a folded state.

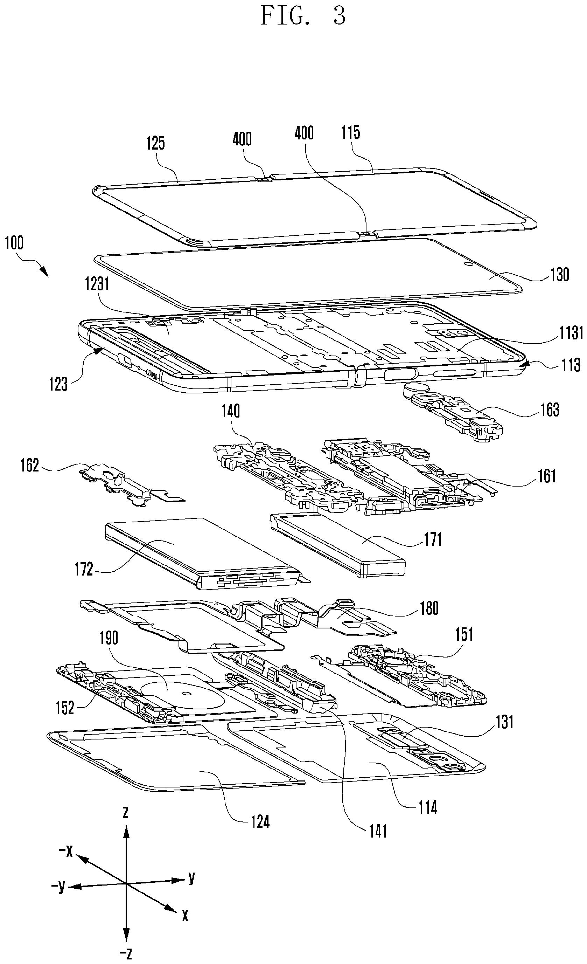

FIG. 3 is an exploded perspective view of the electronic device according to various embodiments.

With reference to FIG. 3, the electronic device 100 may include a first side member 113 (e.g., first side frame), a second side member 123 (e.g., second side frame), and a hinge mechanism 140 (e.g., hinge module or hinge device) rotatably connecting the first side member 113 and the second side member 123. According to an embodiment, the electronic device 100 may include a first support member 1131 (e.g., first support member) at least partially extending from the first side member 113, and a second support member 1231 at least partially extending from the second side member 123. According to an embodiment, the first support member 1131 may be integrally formed with the first side member 113 or may be structurally coupled to the first side member 113. Similarly, the second support member 1231 may be integrally formed with the second side member 123 or may be structurally coupled to the second side member 123. According to an embodiment, the electronic device 100 may include a flexible display 130 disposed to be supported by the first support member 1131 and the second support member 1231. According to an embodiment, the electronic device 100 may include a first rear cover 114 that is coupled to the first side member 113 and provides a first space between itself and the first support member 1131, and a second rear cover 124 that is coupled to the second side member 123 and provides a second space between itself and the second support member 1231. In certain embodiments, the first side member 113 and the first rear cover 114 may be integrally formed. In certain embodiments, the second side member 123 and the second rear cover 124 may be integrally formed. According to an embodiment, the electronic device 100 may include a first housing 110 (e.g., first housing 110 in FIG. 1A) (e.g., first housing structure) provided through the first side member 113, the first support member 1131, and the first rear cover 114. According to an embodiment, the electronic device 100 may include a second housing (e.g., second housing 120 in FIG. 1A) (e.g., second housing structure) provided through the second side member 123, the second support member 1231, and the second rear cover 124. According to an embodiment, the electronic device 100 may include a sub-display 131 that is disposed to be visible from the outside through at least some region of the first rear cover 114.

According to certain embodiments, the electronic device 100 may include a first substrate assembly 161 (e.g., main printed circuit board), a camera assembly 163, a first battery 171, or a first bracket 151, arranged in the first space between the first side member 113 and the first rear cover 114. According to an embodiment, the camera assembly 163 may include a plurality of camera devices (e.g., camera devices 105 and 108 in FIGS. 1A and 2A), and may be electrically connected to the first substrate assembly 161. According to an embodiment, the first bracket 151 may provide a support structure for supporting the first substrate assembly 161 and/or the camera assembly 163, and improved rigidity. According to an embodiment, the electronic device 100 may include a second board assembly 162 (e.g., sub printed circuit board), an antenna 190 (e.g., coil member), a second battery 172, or a second bracket 152, arranged in the second space between the second side member 123 and the second rear cover 124. According to an embodiment, the electronic device 100 may include a wiring member 180 (e.g., FPCB) extending from the first substrate assembly 161 across the hinge mechanism 140 to a plurality of electronic components arranged between the second side member 123 and the second rear cover 124, to provide electrical connections therebetween. According to an embodiment, the antenna 190 may include a near field communication (NFC) antenna, a wireless charging antenna, and/or a magnetic secure transmission (MST) antenna. The antenna 190 may, for example, perform short-range communication with an external device or wirelessly transmit and receive power utilized for charging.

According to certain embodiments, the electronic device 100 may include a hinge housing 141 (e.g., hinge cover) that supports the hinge mechanism 140 and is disposed so as to be exposed to the outside when the electronic device 100 is in the folded state (e.g., folded state of FIG. 2A) and be invisible from the outside by being retracted into the first space and/or the second space when the electronic device 100 is in the unfolded state (e.g., unfolded state of FIG. 1A).

According to certain embodiments, the electronic device 100 may include a first protection cover 115 coupled along the periphery of the first side member 113. According to an embodiment, the electronic device 100 may include a second protection cover 125 coupled along the periphery of the second side member 123. According to an embodiment, in the flexible display 130, the periphery of a first flat portion (e.g., first flat portion 130a in FIG. 1B) may be protected by the first protection cover 115. According to an embodiment, in the flexible display 130, the periphery of a second flat portion (e.g., second flat portion 130b in FIG. 1B) may be protected by the second protection cover 125. According to an embodiment, an electronic device 100 may include a protective member 400 disposed to protect the edges of a third portion (e.g., a third portion 130c of FIG. 1B) corresponding to a hinge device 140 of a flexible display 130.

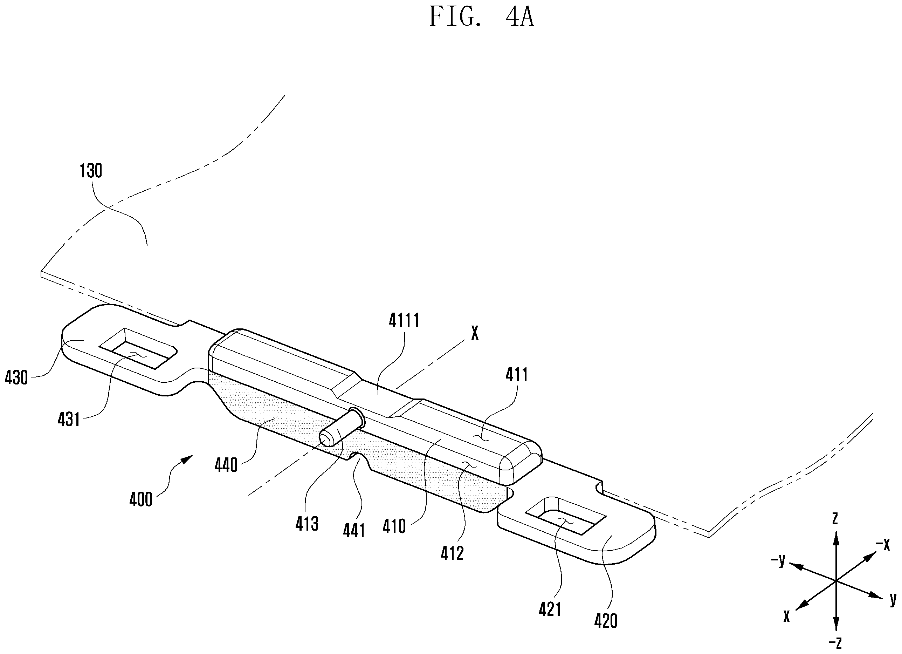

The protective member 400 according to an embodiment of the disclosure is rotatably disposed on the hinge housing 141, and when the display 130 is viewed from above (e.g., from +z direction to -z direction), the protective member 400 is disposed to at least partially overlap the edges of the display 130, and thus easy assembly can be achieved and foreign matter from the outside can be reduced. In addition, the protective member 400 rotatably disposed on the hinge housing 141 is adaptively operated while being rotated along a predetermined rotation axis (e.g., a rotation axis X of FIG. 4A) according to a folding operation of the electronic device, and thus the protective member 400 can contribute to reduction of dents or scratches which may be produced by the protective member 400.

Hereinafter, various embodiments of the protective member 400 will be described in detail.

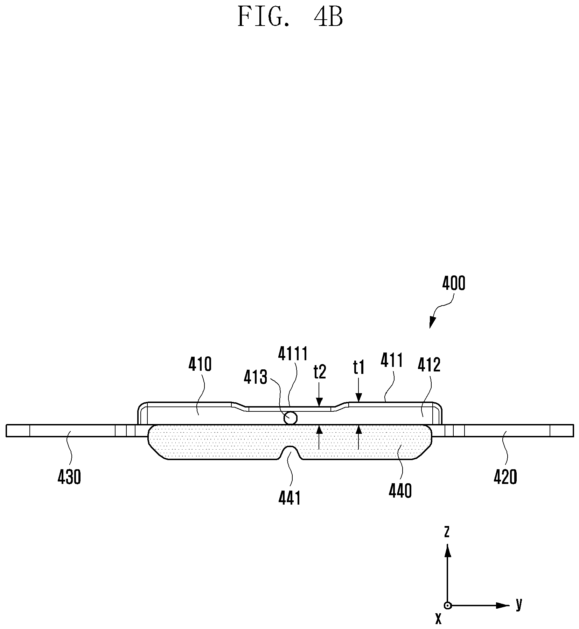

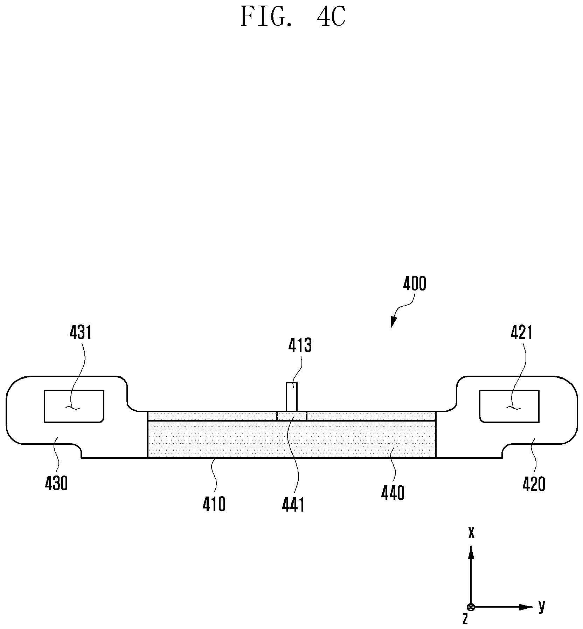

FIG. 4A is a perspective view of a protective member according to various embodiments of the disclosure. FIG. 4B is a front view of the protective member according to various embodiments of the disclosure. FIG. 4C is a bottom view of the protective member according to various embodiments of the disclosure.

The protective member 400 illustrated in and described above with reference to FIG. 4A to FIG. 4C corresponds to the protective member 400 disposed in area 6a of FIG. 1A. However, the protective member 400 disposed in area 6a-1 of FIG. 1A opposite thereto may also have substantially the same configuration.

Referring to FIG. 4A to FIG. 4C, the protective member 400 may include a body 410, a first extension part 420 extending from one end of the body 410, and a second extension part 430 extending from the other end of the body 410. According to an embodiment, the body 410 may include an upper surface 411 and a side surface 412 extending from the upper surface 411. According to an embodiment, when the flexible display 130 is viewed from above, the body 410 may be disposed in a third region (e.g., a third region 130c of FIG. 1A) corresponding to the hinge device (e.g., the hinge device 140 of FIG. 1A and/or the hinge housing 141 of FIG. 3). According to an embodiment, in a third region 130c, the body 410 may be disposed to be viewed from the outside. According to an embodiment, when the flexible display 130 is viewed from above, the first extension part 420 may be disposed on at least a portion of a first area (e.g., a first region 130a of FIG. 1A) corresponding to the first housing (e.g., the first housing 110 of FIG. 1A). According to an embodiment, between the flexible display 130 and a first protection cover (e.g., a first protection cover 115 of FIG. 1A), the first extension part 420 may be disposed not to be viewed from the outside. According to an embodiment, when the flexible display 130 is viewed from above, the second extension part 430 may be disposed on at least a portion of a second region (e.g., a second region 130b of FIG. 1A) corresponding to the second housing (e.g., the second housing 120 of FIG. 1A). According to an embodiment, between the flexible display 130 and a second protection cover (e.g., a second protection cover 125 of FIG. 1A), the second extension part 430 may be disposed not to be viewed from the outside. According to an embodiment, when the flexible display 130 is viewed from above, the body 410 may be disposed to at least partially overlap the edges of the flexible display 130.

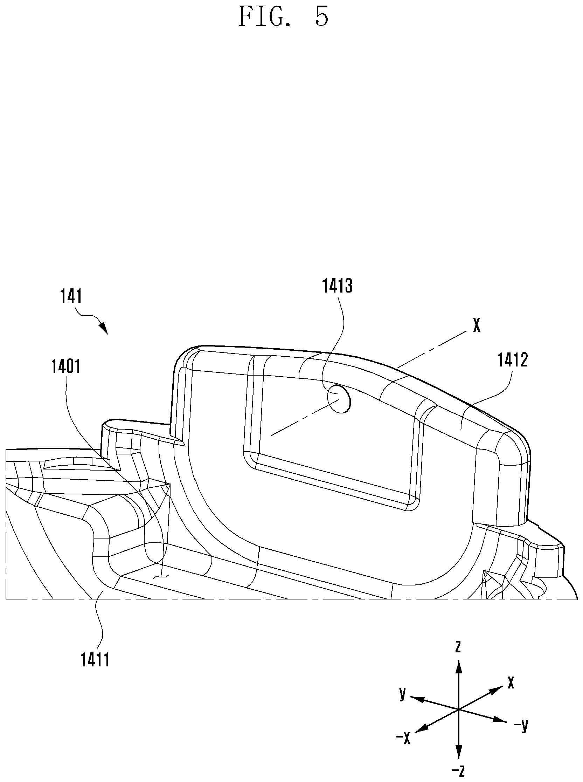

According to various embodiments, the protective member 400 may be made of a bendable polymer material which can be bent together according to a folding operation of the electronic device (e.g., the electronic device 100 of FIG. 1A). For example, the protective member 400 may be made of at least one material among rubber, silicone, or urethane (e.g., thermoplastic polyurethane (TPU)). According to an embodiment, the protective member 400 may be disposed to be rotatable with reference to the rotation axis X at opposite ends of the hinge housing (e.g.f, the hinge housing 141 of FIG. 3), respectively. According to an embodiment, the rotation axis X may be disposed in parallel with the folding axis (e.g., the folding axis A of FIG. 1A). According to an embodiment, when the flexible display 130 is viewed from above, the rotation axis X may be disposed at a position overlapping the folding axis A. According to an embodiment, the protective member 400 may include a shaft 413 (e.g., a hinge pin) extending from a side surface 412 of the body 410 along the rotation axis X to have a predetermined length. According to an embodiment, the shaft 413 may be rotatably coupled to a shaft receiving groove (e.g., a shaft receiving groove 1413 of FIG. 5) disposed on the hinge housing 141 to be described later. In an embodiment, the rotation axis X may be substituted with an insert-molded metal shaft in the body 410 made of a bendable polymer material.

According to various embodiments, the protective member 400 may include a bending structure for assisting bendability according to a folding operation of the electronic device (e.g., the electronic device 100 of FIG. 1A). For example, in the body, the protective member 400 may include a recess 4111 disposed lower than the upper surface 411. According to an embodiment, when the upper surface 411 is viewed from above, the recess 4111 may be disposed, on the left and right with respect to the rotation axis X, in a symmetrical shape. Therefore, when the side surface 412 of the body 410 is viewed from the outside, the thickness t2 of the body 410 of the protective member 400, in an area including the recess 4111, may be configured to be smaller than the thickness t1 of the body 410, in an area not including the recess 4111.

According to various embodiments, the protective member 400 may include a foreign matter blocking cover 440 additionally coupled to the body 410. According to an embodiment, the foreign matter blocking cover 440 may be coupled to the body 410 via double injection molding. In an embodiment, the foreign matter blocking cover 440 may be coupled to the body 410 via bonding, taping, or structural coupling. According to an embodiment, the foreign matter blocking cover 440 may be configured to extend from the body 410 toward the hinge housing (e.g., the hinge housing 141 of FIG. 5). In an embodiment, the foreign matter blocking cover 440, in a case in which the protective member 400 is coupled to the hinge housing 141, may be close to at least a portion of the hinge housing 141, or in contact to at least a portion of the hinge housing 141, in order to block foreign matter introduced into the hinge housing 141 from the outside. According to an embodiment, the foreign matter blocking cover 440 is made of a material having rigidity less than that of the body 410 (e.g., a material having a greater elastic force than that of the body 410), in order to help improve bendability of the body 410. According to an embodiment, when the upper surface 411 is viewed from above, the foreign matter blocking cover 440 may include a groove 441 disposed in an area in which the foreign matter blocking cover overlaps the rotation axis X, in order to help improve bendability of the body 410.

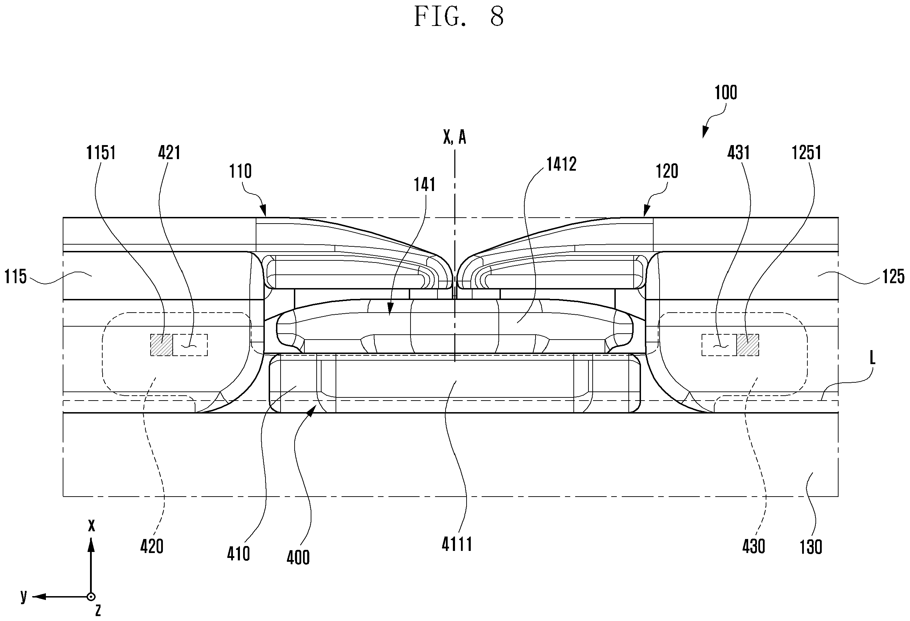

According to various embodiments, the protective member 400 may include a first guide hole 421 (or a groove) disposed through the first extension part 420 and a second guide hole 431 (or a groove) disposed through the second extension part 430. According to an embodiment, the first guide hole 421 may be configured in a shape capable of receiving a first guide protrusion (e.g., a first guide protrusion 1151 of FIG. 8) disposed on the first protection cover (e.g., the first protection cover 115 of FIG. 1A). According to an embodiment, the second guide hole 431 may be configured in a shape capable of receiving a second guide protrusion (e.g., a second guide protrusion 1251 of FIG. 8) disposed on the second protection cover (e.g., the second protection cover 125 of FIG. 1A). According to an embodiment, the first guide hole 421 and the second guide hole 431 may be arranged to have a length along the length direction of the body 410. According to an embodiment, the first guide hole 421 and the second guide hole 431, at the time of folding operation of the electronic device (e.g., the electronic device of FIG. 1A), can help the first and the second extension parts 420 and 430 to prevent separation due to a slip phenomenon occurring between the flexible display 130 and the first and the second protection covers 115 and 125, and perform a sliding operation in the predetermined direction.

FIG. 5 is a partial perspective view of a hinge housing according to various embodiments of the disclosure.

Referring to FIG. 5, the electronic device (e.g., the electronic device 100 of FIG. 3) may include a hinge housing 141 having a receiving part 1401 configured to receive a hinge device (e.g., the hinge device 140 of FIG. 3) (e.g., a hinge module). According to an embodiment, the hinge device 140 may be understood to include the hinge housing 141. According to an embodiment, the hinge housing 141 may include a housing body 1411 including the receiving part 1401, and a support part 1412 extending from opposite ends of the housing body 1411 upwards to have a predetermined height. According to an embodiment, the support part 1412 may include the shaft receiving groove 1413 to which the shaft (e.g., the shaft 413 of FIG. 4A) of the protective member 400 described above is to be rotatably coupled along the rotation axis X. According to an embodiment, the hinge housing 141 may be made of a metal material or a polymer material.

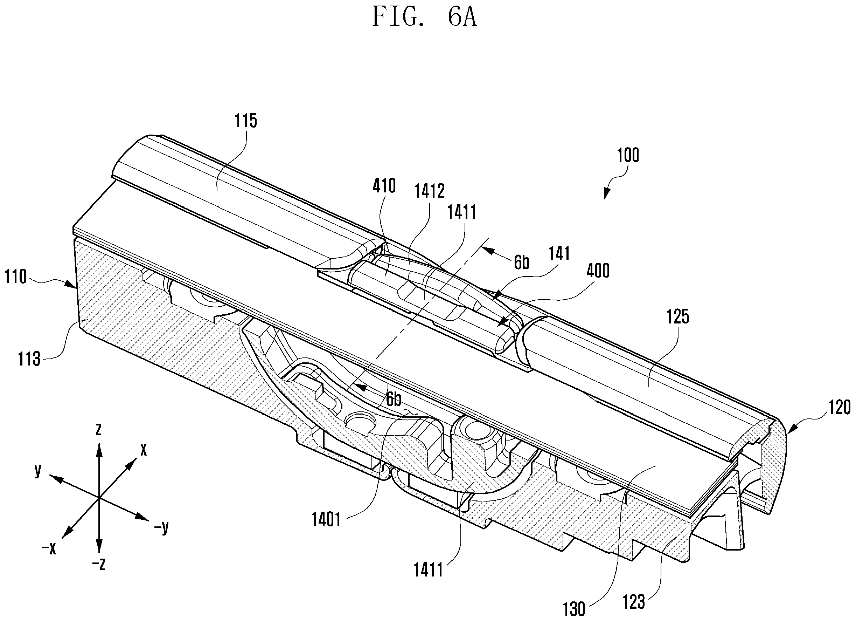

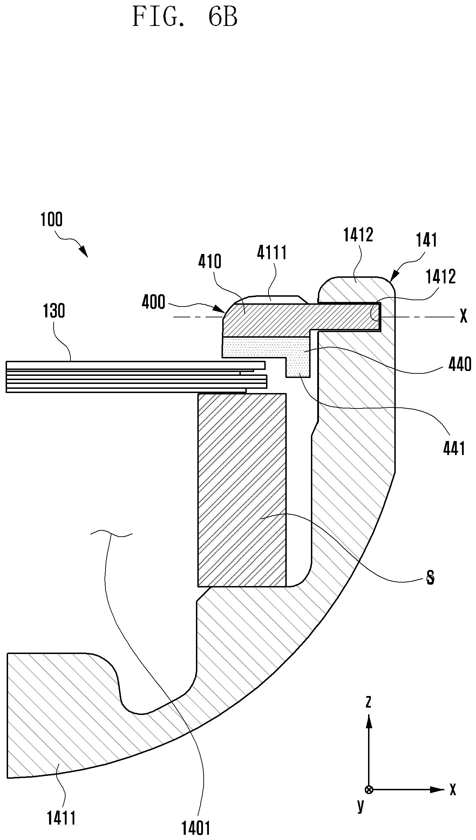

FIG. 6A is a partial sectional perspective view of the electronic device on which a protective member is disposed, in area 6a of FIG. 1A according to various embodiments of the disclosure. FIG. 6B is a partial cross-sectional view of the electronic device taken along line 6b-6b of FIG. 6A according to various embodiments of the disclosure.

The protective member 400 according to an embodiment of the disclosure has been illustrated and described to be disposed in area 6a of FIG. 1A, but embodiments are not limited thereto, and in embodiments the protective member 400 can be disposed in area 6a-1 of FIG. 1A, facing same, in substantially the same manner.

Referring to FIG. 6A and FIG. 6B, the electronic device 100 may include the second housing 120 foldably coupled to the first housing 110 via the first housing 110 and the hinge device (e.g., the hinge device 140 of FIG. 3). According to an embodiment, the hinge device (e.g., the hinge device 140 of FIG. 3) may be received into the receiving part 1401 of the hinge housing 141, in order to be disposed not to be viewed from the outside. According to an embodiment, when the electronic device 100 is in a folded state, the hinge housing 141 may be disposed to be at least partially viewed from the outside, and in an unfolded state, the hinge housing 141 may be covered by the first housing 110 and the second housing 120, in order to be disposed not to be viewed from the outside. In an embodiment, when the electronic device is in the unfolded state, the hinge housing 141 may be disposed to be as least partially viewed from the outside.

According to various embodiments, the electronic device 100 may include the first protection cover 115 coupled to the first housing 110 and the second protection cover 125 coupled to the second housing 120, so that the edges of the flexible display 130 may not be viewed from the outside. According to an embodiment, the protective member 400, between the first protection cover 115 and the second protection cover 125, may be rotatably disposed on the support part 1412 extending from the housing body 1411 of the hinge housing 141 upwards (e.g., z axis direction). According to an embodiment, the body 410 of the protective member 400, between the first protection cover 115 and the second protection cover 125, may be disposed to be viewed from the outside. According to an embodiment, the first extension part 420 of the protective member 400 may be disposed between the flexible display 130 and the first protection cover 115, and the second extension part 430 may be disposed between the flexible display 130 and the second protection cover 125. According to an embodiment, when the flexible display is viewed from above, the body 410 of the protective member 400 may be disposed to at least partially overlap the edges of the flexible display 130. Therefore, all the edges of the flexible display 130 can be protected via the first protection cover 115, the second protection cover 125, and the body 410 of the protective member 400. According to an embodiment, the electronic device 100 may be disposed in the receiving part 1401 of the hinge housing 141, and may include a sweeper S configured to support the rear surface of the flexible display 130.

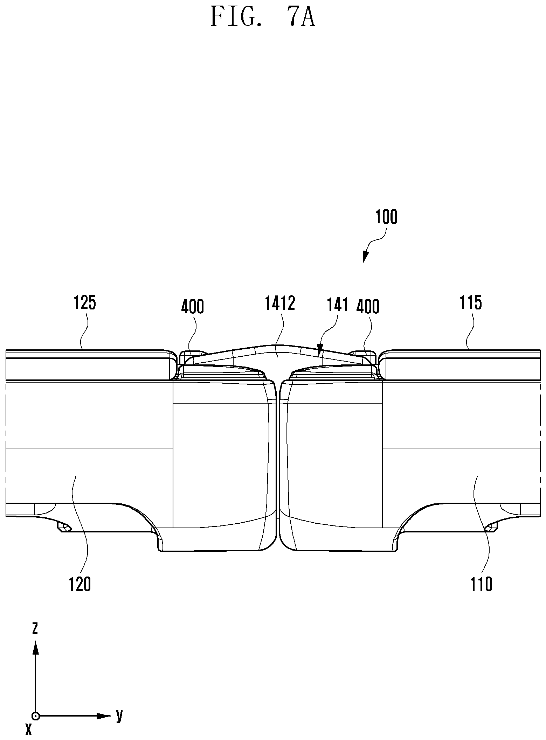

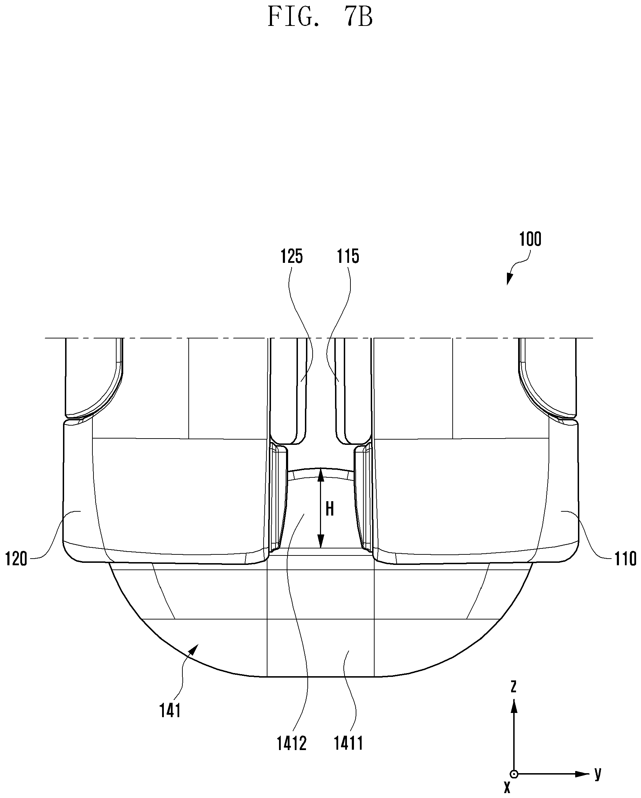

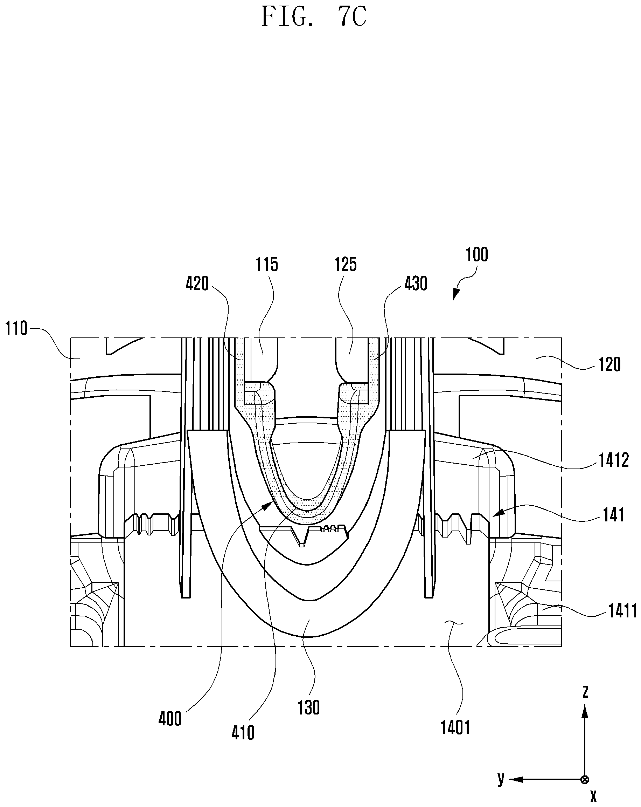

FIG. 7A is a partial configuration view of the electronic device illustrating an unfolded state according to various embodiments of the disclosure. FIG. 7B and FIG. 7C are partial configuration views of the electronic device illustrating a folded state according to various embodiments of the disclosure.

Referring to FIG. 7A to FIG. 7C, the electronic device 100 may include the second housing 120 foldably coupled to the first housing via the first housing 110 and the hinge device (e.g., the hinge device 140 of FIG. 3). According to an embodiment, the electronic device 100 may include the protective member 400 rotatably coupled to the support part 1412 extending from the housing body 1411 of the hinge housing 141 upwards (e.g., z axis direction) to have a predetermined height H. According to an embodiment, the height H of the support part 1412 may be determined by an arrangement, or an arrangement structure, in which the protective member 400 disposed in the support part 1412 is induced to be close to the flexible display 130. According to some embodiments, when the electronic device 100 is in a folded state, the height H of the support part 1412 may be determined by an arrangement, or an arrangement structure, in which at least a part of the gap disposed between the first housing 110 and the second housing 120 may be covered. In an embodiment, the height H of the support part 1412 may be determined by an arrangement, or an arrangement structure, in which the protective member 400 disposed on the support part 1412 is in contact with the flexible display 130. According to an embodiment, when the electronic device 100 is transitioned from an unfolded state to a folded state, the body 410 of the protective member 400 can be folded together with the flexible display, and via a rotatable coupling structure of the body 410, damages on the outer surface of the flexible display 130 can be reduced.

FIG. 8 is a partial plan view of the electronic device on which a protective member is disposed according to various embodiments of the disclosure.

Referring to FIG. 8, the electronic device 100 may include a first housing 110 and a second housing 120 foldably coupled to the first housing 110 via a hinge device (e.g., the hinge device 140 of FIG. 3). According to an embodiment, the electronic device may include the protective member 400 rotatably coupled to the support part extending to a predetermined height H, upwards (e.g., z axis direction) from the housing body of the hinge housing. According to an embodiment, edges L of the flexible display can be covered not to be viewed from the outside via the first protection cover 115, the second protection cover 125, and the protective member.

The electronic device 100 may further include a guide structure for overcoming the concentration of stress applied to the body 410 of the protective member 400 according to the folding operation of the first housing 110 and the second housing 120 and providing smooth bending characteristics capable of preventing strain of the flexible display 130. The protective member 400 may include the first guide hole 421 disposed through the first extension part 420 and configured to receive the first guide protrusion 1151 protruding from the inner surface of the first protection cover 115 toward the first housing 110, and the second guide hole 431 disposed through the second extension part 430 and configured to receive the second guide protrusion 1251 protruding from the inner surface of the second protection cover 125 toward the second housing 120. Therefore, when the electronic device 100 performs a folding operation, the first extension part 420 and the second extension part 430 of the protective member 400 are carried and moved left ward and rightward (e.g., y axis direction or -y axis direction) by the first guide protrusion 1151 and the second guide protrusion 1251 extending through and engaged with the first guide hole 421 and the second guide hole 431, respectively, in order to reduce the concentration of stress applied to the body 410 of the protective member 400. For example, when the electronic device 100 performs a folding operation or an unfolding operation, in order to prevent separation of the first extension part 420 and the second extension part 430, the first guide protrusion 1151 and the second guide protrusion 1251 may protrude up to the first housing 110 and the second housing 120. In an embodiment, the first guide protrusion 1151 and the second guide protrusion 1251 may be structurally coupled to the first housing 110 and the second housing 120, respectively. In an embodiment, the first guide protrusion 1151 and the second guide protrusion 1251 may be configured in a shape (e.g., a hook shape) for preventing separation of the first extension part 420 and the second extension part 430, when the electronic device 100 performs a folding operation or an unfolding operation. In an embodiment, the guide protrusions arranged in the first housing 110 and the second housing 120may be substituted for the first guide protrusion 1151 and the second protrusion 1251 , respectively.

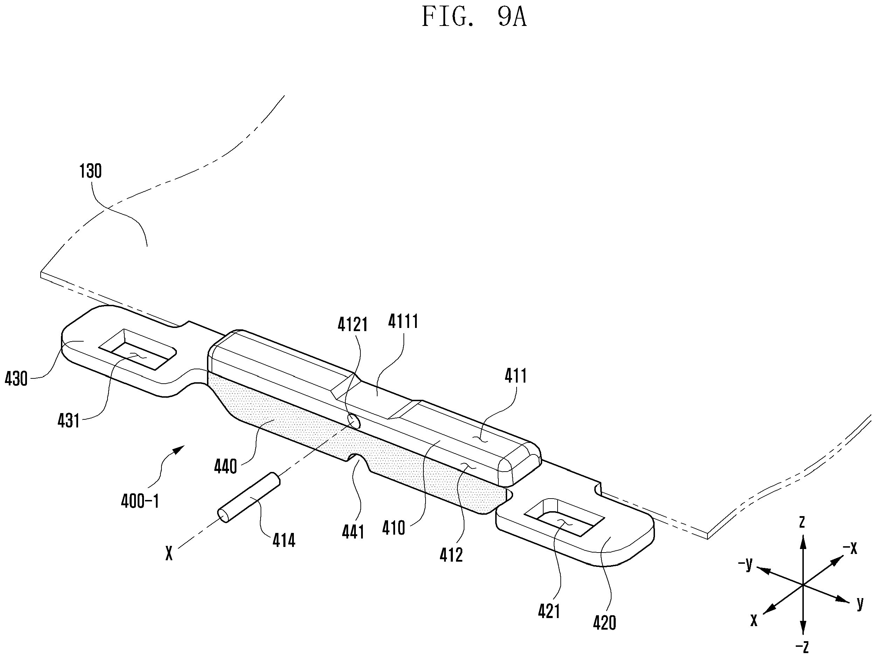

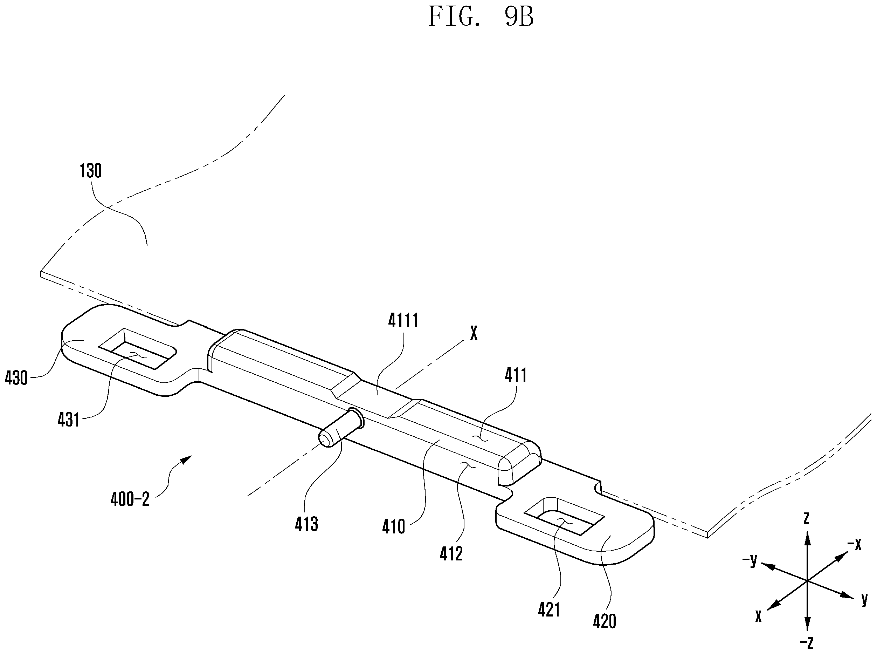

FIG. 9A and FIG. 9B are perspective views of protective members according to various embodiments of the disclosure.

In describing the protective members 400-1 and 400-2 of FIG. 9A and FIG. 9B, the same reference numerals are given to components substantially the same as those of the protective member 400 of FIG. 4A, and detailed descriptions thereof may be omitted.

Referring to FIG. 9A, a protective member 400 may include a body 410, a first extension part 420 extending from one end of the body 410, and a second extension part 430 extending from the other end of the body 410. According to an embodiment, the body 410 may include an upper surface 411 and a side surface 412 extending from the upper surface 411. According to an embodiment, the protective member 400 may include a hinge pin 414 (e.g., a shaft) having a predetermined length that enables the hinge pin to be fixed to a pin receiving groove 4121 disposed on the side surface. According to an embodiment, the hinge pin 414 may be coupled to the body 410 made of a polymer material along the hinge axis via insert injection molding. In the case, the hinge pin 414 may be made of a metal material. According to an embodiment, the protective member 400 may be rotatably coupled to a shaft receiving groove 1413 disposed on a support part (e.g., the support part 1412 of FIG. 5) of a hinge housing (e.g., the hinge housing 141 of FIG. 5), via the hinge pin 414 coupled to the side surface 412 and protruding therefrom. In an embodiment, the protective member 400 may be coupled to the hinge housing in such a way that the shaft protruding from the support part 1412 of the hinge housing 141 is rotatably inserted through or in the through hole disposed in the side surface of the protective member 400.

Referring to FIG. 9B, the protective member 400-2 may be configured to omit the foreign matter blocking cover 400from the configuration of FIG. 4A.

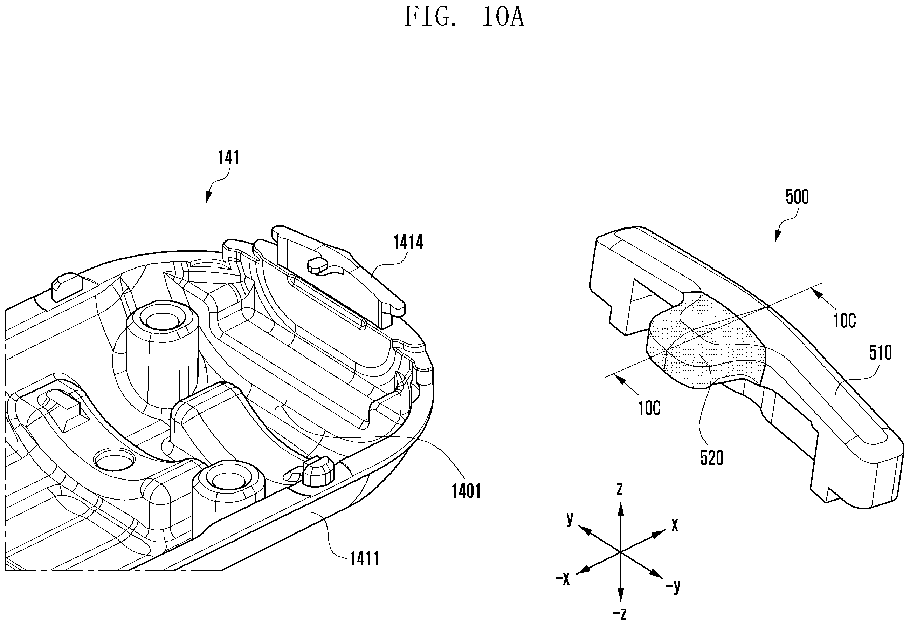

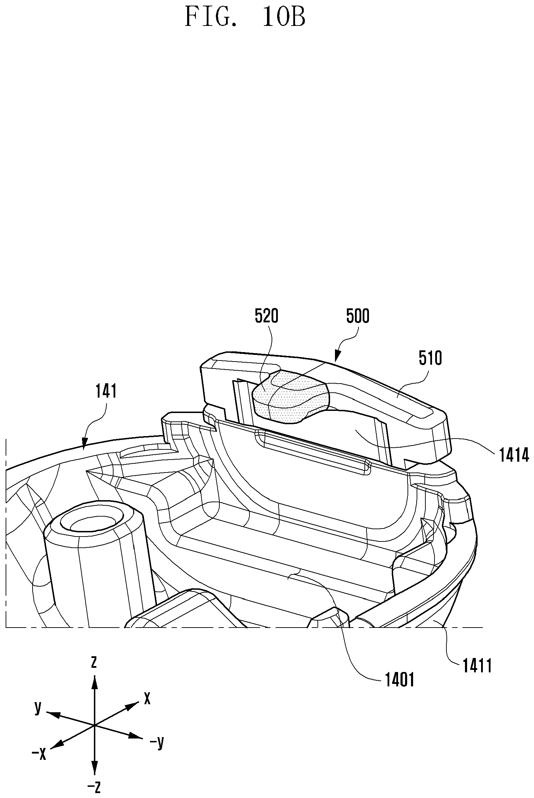

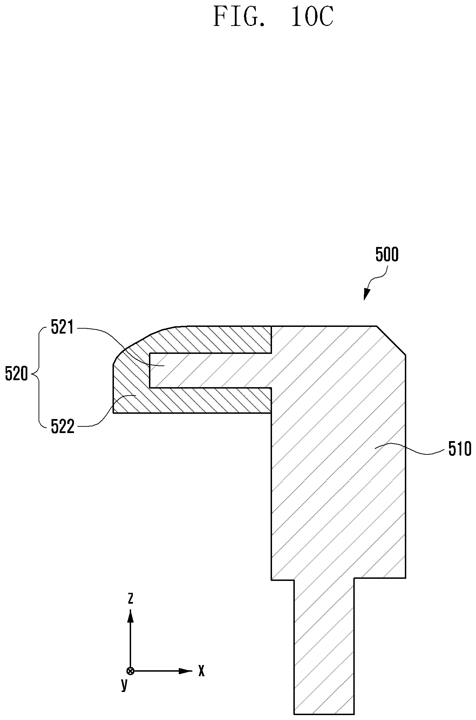

FIG. 10A is an exploded perspective view of a hinge housing and a protective member according to various embodiments of the disclosure. FIG. 10B is a perspective view illustrating a state in which the protective member is coupled to the hinge housing according to various embodiments of the disclosure. FIG. 10C is a cross-sectional view of the protective member taken along line 10c-10c of FIG. 10A according to various embodiments of the disclosure.

Referring to FIG. 10A to FIG. 10C, the hinge housing 141 may include a support part 1414 extending upwards (e.g., z axis direction) from opposite ends of a housing body 1411. According to an embodiment, a protective member 500 may include a coupling part 510 configured to be coupled to the support part of the hinge housing 141 and a protrusion part 520 extending from the coupling part 510 toward the flexible display 130. According to an embodiment, at least a portion of the coupling part 510 and the protrusion part 520 may be made of a metal material or a polymer material (e.g., polycarbonate (PC)). According to an embodiment, when the flexible display 130 is viewed from above in a state in which the coupling part 510 of the protective member 500 is coupled to the support part 1414 of the hinge housing 141, the protrusion part 520 may protrude by an amount allowing the protrusion part to at least partially overlap the edges of the flexible display 130. According to an embodiment, the protrusion part 520 may include a first portion 521 extending from the coupling part 510 and a second portion 522 disposed to at least partially surround the first portion 521. In an embodiment, the first portion 521 may be a separate component structurally coupled to the coupling part 510. According to an embodiment, the second portion 522 is a portion which may be in contact with the flexible display 130 according to an operation of folding and unfolding of the electronic device 100, and may be made of an elastic material to prevent damage of the flexible display 130. In the case, the first portion 521 may provide rigidity to support the flexible display 130, and the second portion 522 may provide elasticity or flexibility to reduce damage of the flexible display 130. According to an embodiment, the first portion 521 and the second portion 522 may be coupled to each other via double injection, bonding, taping, or fusion bonding. According to an embodiment, the first portion may be made of urethane, silicone, or rubber having elasticity. In an embodiment, the protrusion part 520 may be made entirely of an elastic material and coupled to the coupling part 510.

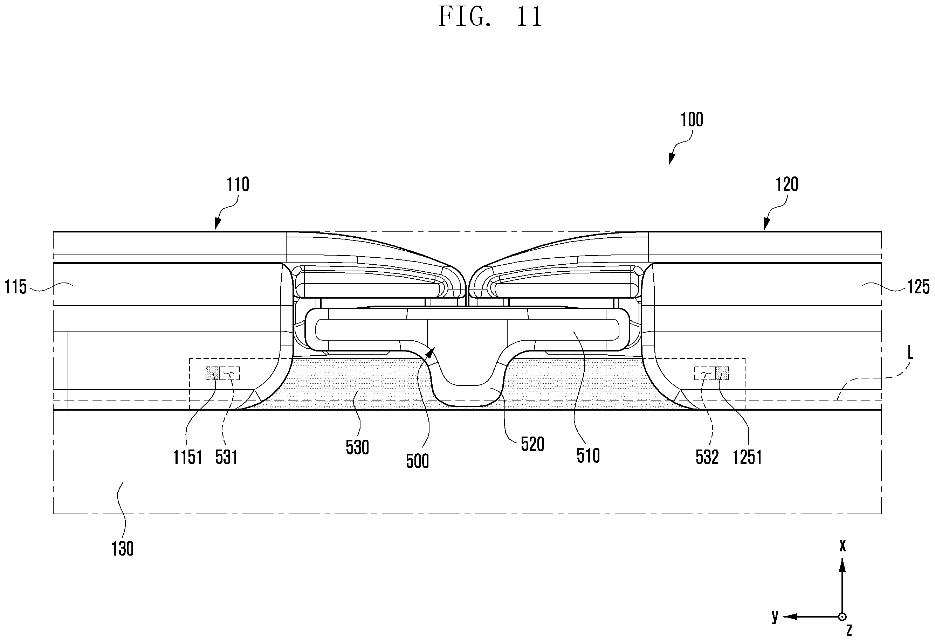

FIG. 11 is a partial plan view of the electronic device on which a protective member and a blocking film are disposed according to various embodiments of the disclosure.

In describing the electronic device of FIG. 11, the same reference numerals are given to components substantially the same as those of the electronic device of FIG. 8, and detailed descriptions thereof may be omitted.

Referring to FIG. 11, the electronic device 100 may include a first housing 110 and a second housing 120 foldably coupled to the first housing 110 via a hinge device (e.g., the hinge device 140 of FIG. 3). According to an embodiment, the electronic device 100 may include a protective member 500 coupled to a support part (e.g., the support part 1414 of FIG. 10A) of a hinge housing (e.g., the hinge housing of FIG. 10A). According to an embodiment, edges L of the flexible display 130 can be covered not to be viewed at least partially from the outside via the first protection cover 115, the second protection cover 125, and the protrusion part 520 of the protective member 500. According to an embodiment, the electronic device 100 may further include a blocking film 530 disposed between the protrusion part 520 of the protective member 500 and the flexible display 130. In this case, the blocking film 530 may include a first guide hole 531 configured to receive a first guide protrusion 1151 disposed between a first protection cover 115 and the flexible display 130 and protruding from the first protection cover 115 toward the first housing 110, and a second guide hole 532 configured to receive a second guide protrusion 1251 disposed between a second protection cover 125 and the flexible display 130 and protruding from the second protection cover 125 toward the second housing 120. Therefore, even while the electronic device 100 performs a folding and unfolding operation, the blocking film 530 can prevent the first and the second guide protrusion 1151 and 1251 from being separated to the outside, through the guide structure where the first and the second guide protrusion 1151 and 1251 are guided in the first and the second guide hole 531 and 532.

According to various embodiments, an electronic device (e.g., the electronic device 100 of FIG. 3) includes: a first housing (e.g., the first housing 110 of FIG. 3); a second housing (e.g., the second housing 120 of FIG. 3); at least one hinge device configured to connect the first housing to be foldable with respect to the second housing with reference to the folding axis (e.g., the folding axis A of FIG. 8); a hinge housing (e.g., the hinge housing 141 of FIG. 8) configured to receive the at least one hinge device; a flexible display (e.g., the flexible display 130 of FIG. 8) including a first region (e.g., the first region 130a of FIG. 1A) corresponding to the first housing, a second region (e.g., the second region 130b of FIG. 1A) corresponding to the second housing, and a folding region (e.g., the third region 130c of FIG. 3) which is foldable and which is configured to connect the first region and the second region; and at least one protective member (e.g., the protective member 400 of FIG. 8) coupled, in an area corresponding to the folding area, to the hinge housing to be rotatable with reference to the rotation axis (e.g., the rotation axis X of FIG. 8) parallel to the folding axis, and which may include a material which is at least partially deformable according to a folding operation of the electronic device, wherein the at least one protective member may be disposed to at least partially overlap at least one edge of the flexible display in the folding area when the flexible display is viewed from above.

According to various embodiments, the at least one protective member may include a body including an upper surface and a side surface extending from the upper surface and may include a shaft extending from the side surface along the rotation axis to have a length, and the shaft of the protective member may be rotatably coupled to the hinge housing.

According to various embodiments, the hinge housing may include a housing body including a receiving part configured to receive the at least one hinge device and a support part extending from opposite ends of the housing body to have a predetermined height in a direction perpendicular to the rotation axis, and the protective member may be coupled to the hinge housing in such a way that the shaft is rotatably coupled to a shaft receiving groove disposed on the support part.

According to various embodiments, the height of the support part may be determined based on an arrangement in which the at least one protective member is disposed adjacent to the flexible display 130.

According to various embodiments, when the electronic device is in a folded state, the height of the support part may be determined based on an arrangement in which at least a part of the gap disposed between the first housing and the second housing can be covered by the support part.

According to various embodiments, the height of the support part may be determined based on an arrangement structure in which the at least one protective member is in contact with the flexible display 130.

According to various embodiments, the shaft may be integrated with the body.

According to various embodiments, the shaft may be coupled to a pin receiving groove disposed on the body.

According to various embodiments, the shaft may be made of a metal material and may be coupled to the body via insert injection molding.

According to various embodiments, the rotation axis may overlap the folding axis from a perspective above the upper surface.

According to various embodiments, the body of the at least one protective member may include a recess disposed lower than the upper surface with reference to the rotation axis.

According to various embodiments, the electronic device may further include a foreign matter blocking cover extending toward the hinge housing and coupled to the body.

According to various embodiments, the foreign matter blocking cover may be made of a material having a rigidity which is less than a rigidity of the body.

According to various embodiments, the foreign matter blocking cover may further include a groove disposed in an area in which the foreign matter blocking cover at least partially overlaps the rotation axis from a perspective above the upper surface.

According to various embodiments, the protective member may include a first extension part extending from the body toward the first housing and a second extension part extending from the body toward the second housing.

According to various embodiments, the first extension part may be disposed to at least partially overlap the at least one edge of the flexible display from the perspective above the flexible display, and the second extension part may be disposed to at least partially overlap the at least one edge of the flexible display from the perspective above the flexible display.

According to various embodiments, the electronic device may include a first protection cover disposed on the first housing in the first region with the first extension part interposed between the first protection cover and the first region, such that the first protection cover overlaps the at least one edge of the flexible display, and a second protection cover disposed on the second housing in the second region with the second extension part interposed between the second protection cover and the second region, such that the second protection cover overlaps the at least one edge of the flexible display.

According to various embodiments, the first extension part may include a first guide hole having a predetermined length, the first protection cover may include a first guide protrusion protruding toward the first housing in order to be guided to the first guide hole, and the at least one protective member movable such that the first guide protrusion moves along the first guide hole according to a folding and an unfolding operation of the electronic device.

According to various embodiments, the second extension part may include a second guide hole having a predetermined length, the second protection cover may include a second guide protrusion protruding toward the second housing in order to be guided to the second guide hole, and the at least one protective member may be movable such that the second guide protrusion moves along the second guide hole according to a folding and an unfolding operation of the electronic device.

According to various embodiments, the at least one protective member may include at least one of a rubber material, a urethane material, or a silicone material.

The embodiments of the disclosure disclosed in the specification and drawings are merely provided for specific examples to easily explain the technical content according to the embodiments of the disclosure and help understanding of the embodiments of the disclosure, and are not intended to limit the scope of the embodiments of the disclosure. Therefore, the scope of various embodiments of the disclosure should be construed to include all changes or modifications derived based on the technical spirit of various embodiments of the disclosure in the scope of various embodiments of the disclosure, in addition to the embodiments disclosed herein.

## Claims

1. An electronic device comprising:
a first housing;
a second housing;
at least one hinge device which connects the first housing and the second housing to be foldable with respect to each other with reference to a folding axis;
a hinge housing which receives the at least one hinge device;
a flexible display including a first region corresponding to the first housing, a second region corresponding to the second housing, and a folding area which is foldable and connects the first region and the second region; and
at least one protective member which is coupled, in an area corresponding to the folding area, to the hinge housing to be rotatable with reference to a rotation axis parallel to the folding axis, the protective member comprising a material which is at least partially deformable according to a folding operation of the electronic device,
wherein the at least one protective member at least partially overlaps at least one edge of the flexible display in the folding area, when the flexible display is viewed from above.

2. The electronic device of claim 1, wherein the at least one protective member comprises:
a body including an upper surface and a side surface extending from the upper surface; and
a shaft disposed at the side surface along the rotation axis to have a length, and wherein the at least one protective member is rotatably coupled to the hinge housing through the shaft.

3. The electronic device of claim 2, wherein the hinge housing comprises:
a housing body including a receiving part which receives the at least one hinge device; and
a support part extending from opposite ends of the housing body to have a height in a direction perpendicular to the rotation axis, and including a shaft receiving groove, and
wherein the shaft is rotatably coupled to the shaft receiving groove.

4. The electronic device of claim 3, wherein the height of the support part is based on an arrangement in which the at least one protective member is disposed adj acent to the flexible display.

5. The electronic device of claim 3, wherein when the electronic device is in a folded state, the height of the support part based on an arrangement in which at least a part of a gap disposed between the first housing and the second housing is covered by the support part.

6. The electronic device of claim 3, wherein the height of the support part is based on an arrangement in which the at least one protective member is in contact with the flexible display.

7. The electronic device of claim 2, wherein the shaft is integrally formed with the body.

8. The electronic device of claim 2, wherein the body further includes a pin receiving groove to which the shaft is coupled.

9. The electronic device of claim 8, wherein the shaft comprises a metal material, and is coupled to the body by insert injection molding.

10. The electronic device of claim 2, wherein the rotation axis overlaps the folding axis when the upper surface is viewed from above.

11. The electronic device of claim 2, wherein the body of the at least one protective member further includes a recess that is lower than the upper surface with reference to the rotation axis.

12. The electronic device of claim 2, further comprising a foreign matter blocking cover extending toward the hinge housing, and coupled to the body.

13. The electronic device of claim 12, wherein the foreign matter blocking cover comprises a material having a rigidity which is less than a rigidity of the body.

14. The electronic device of claim 12, wherein the foreign matter blocking cover further comprises a groove provided in an overlapping area, in which the foreign matter blocking cover at least partially overlaps the rotation axis when the upper surface is viewed from above.

15. The electronic device of claim 2, wherein the electronic device comprises:
a first extension part extending from the body toward the first housing, and
a second extension part extending from the body toward the second housing.
